# FASCICULE DE BREVET EUROPEEN

(11) **EP 3 136 428 B1**
(45) Date de publication et mention de la délivrance du brevet: **13.12.2023**
(21) Numéro de dépôt: 16156430.7
(22) Date de dépôt: 19.02.2016
(51) Int. Cl.: H01L 21/60, H01L 23/485, H01L 21/78, H01L 21/306

(54) **PUCE À MONTAGE EN SURFACE**
CHIP ZUM MONTIEREN AUF DER OBERFLÄCHE
SURFACE-MOUNTED CHIP

(30) Priorité: 31.08.2015 FR 1558067
(43) Date de publication de la demande: 01.03.2017
(73) Titulaire: STMicroelectronics (Tours) SAS, 37100 Tours (FR)
(72) Inventeur: ORY, Olivier, 37100 Tours (FR)
(74) Mandataire: Cabinet Beaumont

(56) Documents cités:
- US-A- 3 640 806
- US-A1- 2006 197 187
- US-A1- 2009 194 880
- US-A1- 2012 025 298
- US-A1- 2012 289 023
- US-A1- 2012 289 047

## Description

### Domaine

La présente demande concerne le domaine des puces semiconductrices. Elle vise plus particulièrement des puces dites à montage en surface, c'est-à-dire des puces comportant, sur au moins une face, des métallisations destinées à être brasées à un dispositif extérieur, par exemple un circuit imprimé ou une autre puce.

### Exposé de l'art antérieur

Dans certaines applications, il existe un besoin pour des puces à montage en surface dans lesquelles les métallisations destinées à être brasées à un dispositif extérieur se prolongent par des portions latérales sur les flancs de la puce. Lorsque le brasage est effectué, une partie du matériau de brasage adhère aux portions latérales des métallisations, ce qui permet une inspection visuelle de la qualité des connexions. Ce besoin existe par exemple pour des domaines sensibles tels que le domaine automobile ou le domaine médical.

Un exemple de procédé de réalisation d'une puce à montage en surface comprenant une métallisation se prolongeant sur un flanc de la puce est décrit dans les demandes de brevet

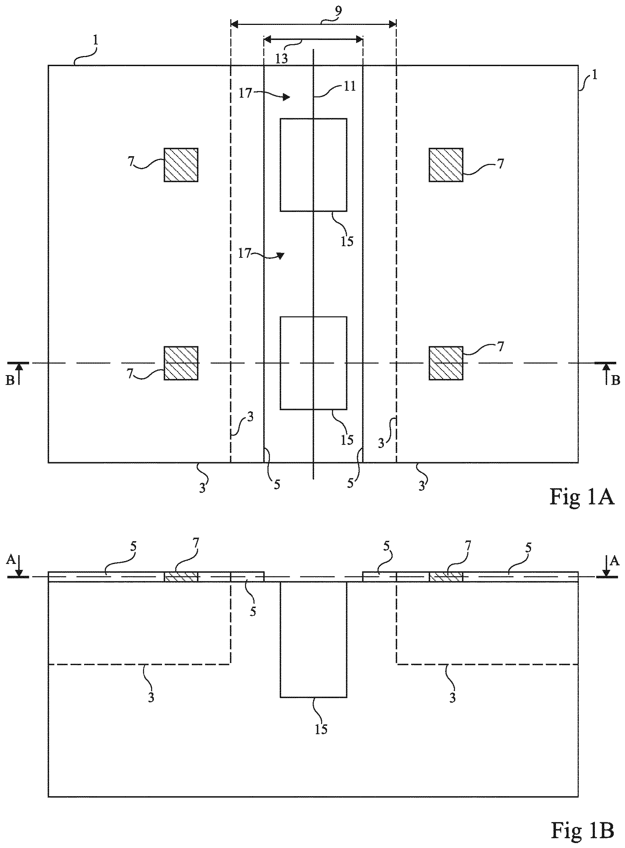

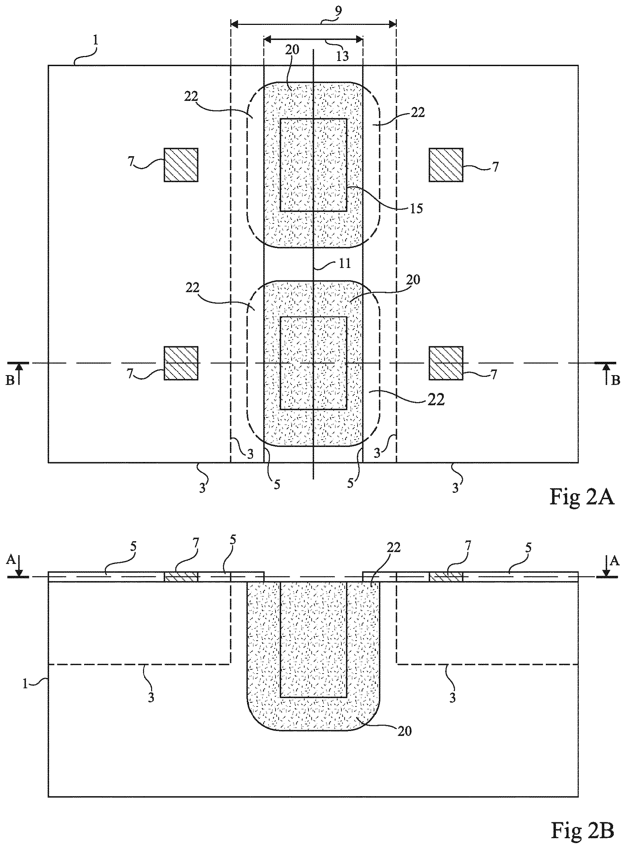

US2012/0054760 , US2012/0289047 A1, US2012/0025298 A1 et US2009/0194880 A1. La métallisation des exemples des documents US2012/0289047 A1 (cf. figures 4v et 8) et US2012/0025298 A1 (cf. figures 2A-D et 7A-B) a la forme d'un canal vertical plane disposé dans une rainure verticale sur le flanc de la puce et elle est séparée du substrat de la puce par une région isolante déposée sur le substrat. La métallisation de l'exemple du document US2009/0194880 A1 (cf. figures 1A-C) a la forme d'un canal vertical en creux disposé dans une rainure verticale sur le flanc de la puce, mais elle n'est pas séparée du substrat de la puce par une région isolante. Ces procédés présentent toutefois des inconvénients et posent notamment des difficultés pratiques de mise en oeuvre. Résumé

La présente invention est définie par les revendications. Un mode de réalisation prévoit une puce à montage en surface réalisée dans et sur un substrat de silicium ayant une face avant et un flanc, la puce comprenant :
au moins une métallisation destinée à être brasée à un dispositif extérieur, cette métallisation comprenant une première portion recouvrant au moins une partie de la face avant du substrat, et une deuxième portion recouvrant au moins une partie du flanc du substrat ; et
une région en silicium poreux, incluse dans le substrat, séparant la deuxième portion de la métallisation du reste du substrat, dans laquelle
la deuxième portion de la métallisation a la forme d'un canal vertical en creux disposé dans une rainure située sur le flanc du substrat.

Selon un mode de réalisation, la puce comprend en outre :
une zone active formée dans et sur le substrat et contenant un circuit électronique ; et
au moins une région de contact connectée au circuit électronique et située sur la face avant de la puce,
dans laquelle la première portion de la métallisation est connectée à la région de contact.

Selon un mode de réalisation, une couche d'isolation est disposée entre la face avant du substrat et la première portion de la métallisation.

Selon un mode de réalisation, la région en silicium poreux est en contact avec la couche d'isolation dans une zone de recouvrement.

Un autre mode de réalisation prévoit un procédé de réalisation d'une puce à montage en surface dans et sur un substrat de silicium, le procédé comprenant les étapes suivantes :
a) graver une ouverture depuis la face supérieure du substrat, cette ouverture définissant une partie d'un flanc de la puce ;
b) former une région en silicium poreux s'étendant dans le substrat à partir des parois latérales de l'ouverture ; et
c) former une métallisation destinée à être brasée à un dispositif extérieur, cette métallisation comprenant une première portion recouvrant au moins une partie de la face supérieure du substrat, et se prolongeant par une deuxième portion s'étendant sur toute la surface des parois latérales de l'ouverture; et (d) découper selon une bande de découpe centrée sur une ligne de découpe passant par l'ouverture.

Selon un mode de réalisation, lors de l'étape de découpe, la bande de découpe a une largeur inférieure à la largeur des ouvertures.

Selon un mode de réalisation, le procédé comprend une étape de meulage de la face inférieure du substrat.

Selon un mode de réalisation, à l'étape c), la formation de la métallisation comprend une étape de dépôt électrochimique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B, 2A, 2B, 3A, 3B, 4A, 4B et 4C représentent schématiquement des étapes d'un mode de réalisation d'un procédé de fabrication d'une puce à montage en surface.

### Description détaillée

De mêmes éléments ont été désignés par de mêmes références aux différentes figures et, de plus, les diverses figures ne sont pas tracées à l'échelle.

Dans la description qui suit, lorsque l'on fait référence à des qualificatifs de position absolue, tels que les termes "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des vues en coupe des figures 1B, 2B, 3B, 4B, étant entendu que, dans la pratique, les dispositifs décrits peuvent être orientés différemment. Sauf précision contraire, les expressions "approximativement", "sensiblement", et "de l'ordre de" signifient à 10 % près, de préférence à 5 % près, ou, s'agissant de qualificatifs d'orientation, à 10 degrés près, de préférence à 5 degrés près.

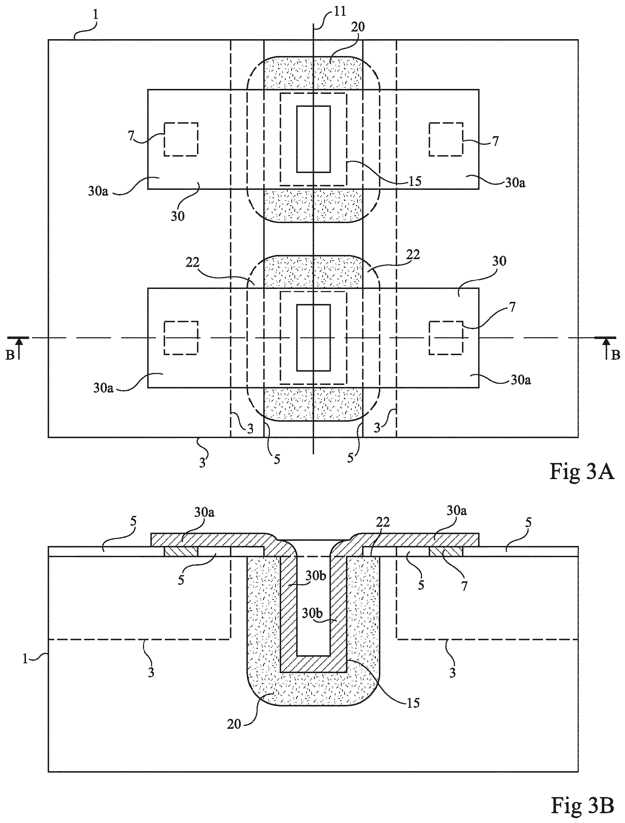

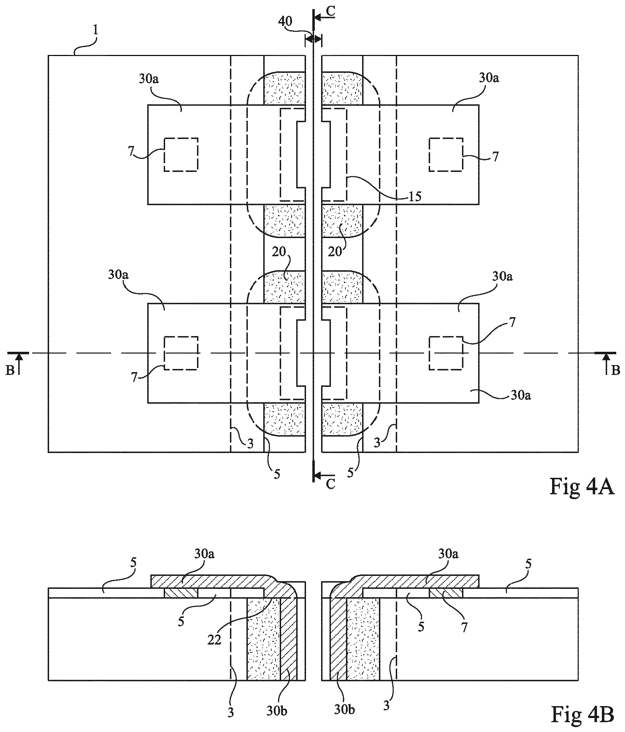

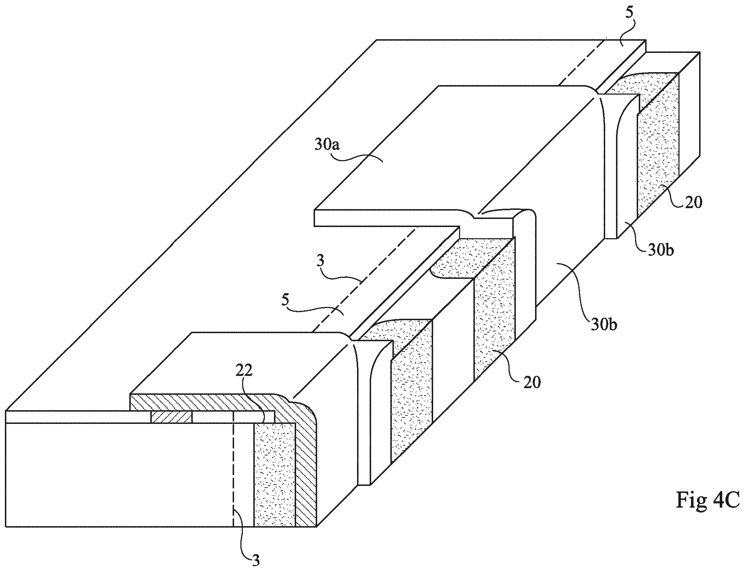

Les figures 1A, 1B, 2A, 2B, 3A, 3B, 4A, 4B et 4C représentent schématiquement des étapes d'un exemple d'un mode de réalisation d'un procédé de fabrication d'une puce à montage en surface. Les figures 1B, 2B, 3B, 4B sont des vues en coupe selon le plan B-B des figures 1A, 2A, 3A, 4A. Les figures 1A et 2A sont des vues en coupe selon le plan A-A des figures 1B et 2B. Les figures 3A et 4A sont des vues de dessus. La figure 4C est une vue en perspective, coupée selon les plans B-B et C-C de la figure 4A.

Les étapes décrites ci-après concernent la réalisation simultanée de plusieurs puces, par exemple identiques, à partir d'un même substrat 1 de silicium. Par souci de simplification, seules deux portions de deux puces voisines sont représentées sur les figures, ces portions étant en vis-à-vis l'une de l'autre respectivement dans une partie gauche et dans une partie droite des figures. Chacune des puces comprend, dans et sur le substrat 1, une zone active 3 dans laquelle est formé un circuit électronique comprenant un ou plusieurs composants semiconducteurs (non représentés). La surface supérieure de la zone active 3 est intégralement recouverte par une couche d'isolation 5, à l'exception d'une ou plusieurs régions de contact 7 connectées au circuit électronique. Les étapes décrites ci-après concernent plus particulièrement la réalisation, dans chaque puce, d'au moins une métallisation destinée à être brasée à un dispositif extérieur, cette métallisation comprenant une portion supérieure en contact avec une ou plusieurs régions de contact 7 de la puce, et une portion latérale sur un flanc de la puce.

Les figures 1A et 1B représentent une étape dans laquelle on part du substrat 1, dans et sur lequel les zones actives 3, la couche d'isolation 5 et les régions de contact 7 ont été réalisées préalablement. A ce stade, la découpe du substrat en puces individuelles n'a pas encore eu lieu. Les zones actives 3 de puces voisines sont séparées, en vue de dessus, par des bandes d'espacement 9 à l'intérieur de chacune desquelles une ligne de découpe 11 est définie. Sur les figures, seules une partie d'une bande d'espacement 9 et une partie correspondante d'une ligne de découpe 11 sont visibles.

Dans l'exemple représenté, dans une bande 13, incluse dans la bande d'espacement 9 et contenant la ligne de découpe 11, la couche d'isolation 5 est retirée, laissant la surface du substrat 1 apparente. Dans cet exemple, la largeur de la bande 13 est inférieure à la largeur de la bande d'espacement 9, et, vue de dessus, la bande 13 est strictement incluse dans la bande 9, c'est-à-dire que les bords de la bande 13 sont distants des bords de la bande 9. Ainsi, de chaque côté de la bande 13, la couche d'isolation 5 recouvre le substrat 1 dans une partie de la bande d'espacement 9.

Dans une portion de la bande 13 située entre deux puces voisines, une ou plusieurs ouvertures localisées 15 sont gravées dans le substrat 1, à partir de la face supérieure du substrat. En vue de dessus, chaque ouverture 15 est traversée par la ligne de découpe 11 incluse dans la bande 13. La dimension des puces dans la direction de la ligne de découpe 11 est supérieure à la somme des dimensions des ouvertures 15 le long de la ligne de découpe. Autrement dit au moins un espace 17 non gravé est maintenu dans la bande 13 entre les puces le long de la ligne de découpe 11.

Dans l'exemple représenté, deux ouvertures 15 sont visibles, chacune étant située entre une région de contact 7 de la puce située en partie gauche des figures et une région de contact 7 de la puce située en partie droite des figures. Dans l'exemple représenté, les ouvertures 15 ont, en vue de dessus, la forme de rectangles, bien que d'autres formes soient possibles. Dans cet exemple, les ouvertures 15 s'étendent, verticalement, sur une profondeur supérieure à l'épaisseur du substrat 1 occupée par les parties actives 3. Dans cet exemple, les ouvertures 15 ne sont pas traversantes, c'est-à-dire qu'elles s'étendent, verticalement, sur une profondeur inférieure à l'épaisseur du substrat 1. A titre de variante, les ouvertures 15 peuvent être traversantes.

Les ouvertures 15 peuvent être réalisées par un procédé de gravure plasma, par exemple par un procédé de type RIE, de l'anglais "Reactive Ion Etching" (gravure ionique réactive). Plus généralement, tout autre procédé permettant de former des ouvertures localisées dans les bandes d'espacement peut être utilisé, par exemple une gravure chimique ou laser.

Les figures 2A et 2B représentent une étape dans laquelle, après l'étape représentée en figures 1A et 1B, des régions en silicium poreux 20 sont formées dans le substrat 1 à partir des parois latérales et du fond des ouvertures 15. En vue de dessus, les régions en silicium poreux 20 sont comprises à l'intérieur de la bande d'espacement 9. Plus particulièrement, en vue de dessus, chaque ouverture 15 est entourée d'une région en silicium poreux 20, qui s'étend à partir des parois latérales de l'ouverture 15 jusque dans des portions de substrat 1 situées sous la couche d'isolation 5. Ainsi, dans des zones de recouvrement 22, des portions des régions en silicium poreux 20 ont leurs faces supérieures en contact avec la face inférieure de la couche d'isolation 5. Dans l'exemple représenté, le fond et les parois latérales de chaque ouverture 15 sont complètement entourées par une région en silicium poreux 20, de sorte que l'ouverture 15 est isolée du reste du substrat par la région 20. Dans cet exemple, des zones de recouvrement 22 sont présentes de part et d'autre de la ligne de découpe 11 au niveau de chaque ouverture 15.

Les régions en silicium poreux 20 peuvent être réalisées par exemple par un procédé de dissolution électrochimique. Pour cela, un masque qui recouvre la face supérieure de l'assemblage des figures 1A et 1B à l'exception des ouvertures 15 peut être réalisé. L'ensemble peut ensuite être plongé dans une solution d'acide fluorhydrique entre une première électrode en vis-à-vis de la face inférieure de l'assemblage, et une deuxième électrode en vis-à-vis de la face supérieure de l'assemblage. La circulation d'un courant et un éclairage éventuel avec une longueur d'onde appropriée, sont réglés de façon à provoquer, au niveau des parois latérales et du fond des ouvertures 15, la dissolution d'une partie du silicium du substrat 1. De cette manière, au niveau de chaque ouverture 15, une région du substrat 1 entourant l'ouverture 15 est transformée en silicium poreux. Dans l'exemple représenté, les régions de silicium poreux 20 associées aux différentes ouvertures 15 sont disjointes. A titre de variante, on peut former une région de silicium poreux continue s'étendant, en vue de dessus, sur toute la surface de la bande 13, cette région débordant sous la couche d'isolation 5 au niveau des zones de recouvrement 22.

Une fois les régions en silicium poreux 20 formées, une étape d'oxydation du silicium poreux peut être prévue, par exemple par oxydation thermique. L'oxydation du silicium poreux permet d'augmenter les propriétés isolantes des régions 20. Cette étape d'oxydation est toutefois optionnelle.

Les figures 3A et 3B représentent une étape dans laquelle, après l'étape représentée en figures 2A et 2B, des métallisations 30 destinées à être brasées à un dispositif extérieur sont réalisées. Chaque métallisation 30 comprend au moins une portion supérieure 30a recouvrant une partie de la face supérieure ou face avant d'au moins une des puces formées dans et sur le substrat 1, et une portion latérale 30b recouvrant au moins une partie d'une paroi latérale d'une ouverture 15 bordant la puce. Sur chaque puce, au moins une région de contact 7 de la puce est en contact avec une portion supérieure 30a d'une métallisation 30.

Dans l'exemple représenté, pour chacune des ouvertures 15, une métallisation 30 est réalisée, cette métallisation 30 recouvrant les parois latérales et le fond de l'ouverture 15, et se prolongeant par une première portion supérieure 30a sur la face supérieure de la puce située en partie gauche de la figure, et par une deuxième portion supérieure 30a sur la face supérieure de la puce située en partie droite de la figure. Dans l'exemple représenté, chaque métallisation 30 a sa première portion supérieure 30a en contact avec une région de contact 7 de la puce située en partie gauche de la figure, et sa deuxième portion supérieure 30a en contact avec une région de contact 7 de la puce située en partie droite de la figure.

Les métallisations 30 sont par exemple réalisées par un procédé de dépôt électrochimique. Pour cela, un masque, non représenté, peut-être réalisé, ce masque recouvrant l'intégralité de la face supérieure de l'assemblage des figures 2A et 2B à l'exception des endroits où les métallisations doivent être déposées. Une couche d'amorce peut ensuite être déposée, par exemple par un procédé de pulvérisation. Une fois la couche d'amorce déposée, un dépôt électrochimique peut être réalisé à partir de cette couche d'amorce, de façon à former les métallisations 30. A titre de variante, plusieurs dépôts électrochimiques successifs peuvent être réalisés successivement pour obtenir des métallisations 30 comprenant plusieurs couches de métaux distincts. Plus généralement, tout autre procédé de dépôt adapté peut être utilisé pour former les métallisations 30.

Les figures 4A, 4B et 4C représentent une étape dans laquelle, après l'étape représentée en figures 3A et 3B, le substrat 1 est découpé en puces individuelles le long de chacune des lignes de découpe 11, par exemple par sciage, par découpe laser ou chimique, par clivage, ou par tout autre procédé de découpe adapté. En vue de dessus, une bande ou zone de découpe 40 centrée sur la ligne de découpe 11 est retirée entre deux puces voisines de façon à dissocier les puces. La largeur des ouvertures 15 est supérieure à la largeur de la bande de découpe 40. Plus particulièrement, la largeur des ouvertures 15 est choisie de façon que les portions latérales 30b des métallisations 30 situées sur les flancs des puces ne soient pas retirées lors de la découpe. Pour cela, dans l'exemple représenté, la largeur L₁₅ des ouvertures 15 est telle que L₁₅ - 2*e_{30b} > L₄₀, e_{30b} étant l'épaisseur des portions latérales 30b des métallisations 30, et L₄₀ étant la largeur de la bande 40.

Dans l'exemple représenté, avant l'étape de découpe proprement dite, une étape préalable de meulage de la face inférieure ou face arrière du substrat 1, est réalisée. Lors de l'étape de meulage, une partie du substrat 1 est retirée sur toute la surface de l'assemblage depuis la face inférieure du substrat 1. Le meulage est interrompu avant d'atteindre les zones actives 3. Le meulage est par exemple interrompu à un niveau intermédiaire entre la face supérieure des portions de métallisation 30 revêtant le fond des ouvertures 15, et la face inférieure des zones actives 3. Ainsi, à l'issue de l'étape de meulage, les ouvertures 15 débouchent sur la face arrière du substrat 1. A titre de variante, le meulage peut être interrompu avant d'atteindre le fond des ouvertures 15. Dans une autre variante, l'étape de meulage peut être omise.

Après la découpe, chacune des puces comprend au moins une métallisation 30 dont une portion supérieure 30a recouvre une partie de la face supérieure de la puce, et dont une portion latérale 30b recouvre une partie d'un flanc de la puce, au moins une région 7 de la puce étant en contact avec une portion supérieure 30a d'une métallisation 30. Chaque métallisation 30 a sa portion latérale 30b isolée du reste du substrat 1 par une région de silicium poreux 20. L'isolation des portions supérieures 30a des métallisations 30 est assurée notamment par la couche isolante 5. Les zones de recouvrement 22 assurent la continuité de l'isolation entre l'isolation par la couche isolante 5 et l'isolation par les régions de silicium poreux 20.

Chaque métallisation 30 est par exemple constituée d'une couche de cuivre recouverte d'une couche d'étain.

A titre d'exemple, les ouvertures 15 ont une largeur comprise entre 50 µm et 100 µm, les métallisations ont une épaisseur comprise entre 0,8 µm et 6 µm, et les bandes de découpe 40 ont une largeur comprise entre 10 µm et 30 µm. Les régions en silicium poreux 20 ont par exemple une épaisseur comprise entre 10 et 50 µm.

Un avantage du procédé décrit ci-dessus est qu'il permet d'obtenir des puces ayant, sur leur face avant, des métallisations 30 destinées à être brasées à un dispositif extérieur, ces métallisations 30 se prolongeant sur une partie des flancs de la puce, ce qui permet de réaliser une inspection visuelle de la qualité des connexions.

Un autre avantage des puces ainsi obtenues est que l'isolation entre les portions latérales 30b des métallisations 30 et le substrat 1 est réalisée par des régions en silicium poreux 20 formées dans le substrat 1. Ainsi, il est possible d'adapter aisément l'épaisseur d'isolation en fonction des besoins de l'application. En particulier, on peut facilement réaliser des régions de silicium poreux 20 d'épaisseur importante, par exemple supérieure à 10 µm, ce qui permet notamment de réduire les couplages capacitifs entre les métallisations 30 et le substrat 1. La présence de régions de silicium poreux 20 d'épaisseur importante permet en outre de limiter le risque de court-circuit entre une métallisation 30 et le substrat 1 au cours de l'étape de découpe.

Un autre avantage des puces obtenues par le procédé décrit ci-dessus est que, du fait que la largeur des ouvertures 15 est supérieure à la largeur de la bande de découpe 40, les portions latérales 30b des métallisations 30 présentent des formes en creux. Plus particulièrement, dans l'exemple représenté, les portions latérales 30b des métallisations 30 ont la forme de canaux verticaux disposés dans des rainures verticales situées sur les flancs de la puce. Cette géométrie permet d'améliorer l'adhérence du matériau de brasage sur les flancs de la puce. De plus, cette géométrie permet de faciliter le contrôle visuel de la brasure. En outre, cette géométrie permet de localiser le matériau de brasure à l'intérieur des canaux verticaux, limitant ainsi le risque de court-circuit entre des métallisations 30 voisines.

Un autre avantage du procédé décrit ci-dessus est que les espaces 17 non gravés, maintenus entre les puces le long de la ligne de découpe 11 lors de l'étape décrite en relation avec les figures 1A et 1B, peuvent recevoir des éléments utiles à la fabrication des puces, comme, par exemple, des repères d'alignement permettant de faciliter le positionnement du substrat au cours des différentes étapes du procédé, des éléments de contrôle de gravure, ou des éléments de contrôle électrique.

Des modes de réalisation particuliers ont été décrits. Diverses variantes et modifications apparaîtront à l'homme de l'art. En particulier, l'étape décrite en relation avec les figures 1A et 1B de retrait de la couche d'isolation 5 dans une bande 13 s'étendant de part et d'autre de la ligne de découpe 11, est optionnelle. A titre de variante, la couche d'isolation 5 peut être conservée dans la bande 13, et les ouvertures 15 réalisées à partir de la face supérieure de la couche d'isolation 5.

En outre, les modes de réalisation décrits ne se limitent pas à l'exemple décrit en relation avec les figures 1A et 1B dans lequel les ouvertures 15 s'étendent, verticalement, sur une profondeur supérieure à l'épaisseur des zones actives 3 et inférieure à l'épaisseur du substrat 1. A titre de variante, les ouvertures 15 formées à l'étape décrite en relation avec les figures 1A et 1B peuvent avoir une profondeur inférieure à l'épaisseur des zones actives 3 ou traverser entièrement le substrat 1.

De plus, les modes de réalisation décrits ne se limitent pas aux exemples susmentionnés dans lesquels seule la face supérieure du substrat 1 supporte des métallisations se prolongeant sur les flancs du substrat. A titre de variante, chacune des faces supérieure et inférieure du substrat peut être munie de métallisations se prolongeant sur les flancs du substrat.

A titre d'exemple, des métallisations de la face inférieure et des métallisations de la face supérieure peuvent être reliées par des portions de métallisation situées sur les flancs du substrat. Lorsque le circuit électronique de la puce a des régions de contact sur la face inférieure du substrat, par exemple des contacts avec des composants à fonctionnement vertical, les contacts peuvent de cette manière être ramenés vers des métallisations de la face supérieure destinées à être brasées à un dispositif extérieur. Les contacts de la face supérieure peuvent aussi être ramenés de cette manière vers des métallisations de la face inférieure destinées à être brasées, par exemple, à une autre puce.

A titre de variante, les métallisations de la face inférieure peuvent être indépendantes des métallisations de la face supérieure, c'est-à-dire non connectées à des métallisations de la face supérieure.

## Revendications

1. Puce à montage en surface réalisée dans et sur un substrat de silicium (1) ayant une face avant et un flanc, la puce comprenant :
au moins une métallisation (30) configurée pour être brasée à un dispositif extérieur, cette métallisation comprenant une première portion (30a) recouvrant au moins une partie de la face avant du substrat, et une deuxième portion (30b) recouvrant au moins une partie du flanc du substrat ; **caractérisée en ce qu'**elle comporte
une région en silicium poreux (20), incluse dans le substrat, isolant la deuxième portion (30b) de la métallisation (30) du reste du substrat,
dans laquelle la deuxième portion (30b) de la métallisation (30) a la forme d'un canal vertical en creux disposé dans une rainure verticale située sur le flanc du substrat (1).

2. Puce selon la revendication 1, comprenant en outre :
une zone active (3) formée dans et sur le substrat (1) et contenant un circuit électronique ; et
au moins une région de contact (7) connectée au circuit électronique et située sur la face avant de la puce,
dans laquelle la première portion (30a) de la métallisation (30) est connectée à la région de contact (7).

3. Puce selon la revendication 1 ou 2, dans laquelle une couche d'isolation (5) est disposée entre la face avant du substrat (1) et la première portion (30a) de la métallisation (30) .

4. Puce selon la revendication 3, dans laquelle au moins une portion de la région en silicium poreux (20) a une face supérieure en contact avec une face inférieure de la couche d'isolation (5).

5. Procédé de réalisation d'une puce à montage en surface dans et sur un substrat de silicium (1), le procédé comprenant les étapes suivantes :
a) graver une ouverture (15) depuis la face supérieure du substrat (1), cette ouverture définissant une partie d'un flanc de la puce ;
b) former une région en silicium poreux (20) s'étendant dans le substrat (1) à partir des parois latérales de l'ouverture (15) ;
c) former une métallisation (30) configurée pour être brasée à un dispositif extérieur, cette métallisation (30) comprenant une première portion (30a) recouvrant au moins une partie de la face supérieure du substrat, et se prolongeant par une deuxième portion (30b) s'étendant sur toute la surface des parois latérales de l'ouverture (15) de sorte que la portion latérale (30b) est isolée du reste du substrat (1) par une portion de silicium poreux (20) (15) ; et
d) découper selon une bande de découpe (40) centrée sur une ligne de découpe (11) passant par l'ouverture (15).

6. Procédé selon la revendication 5, dans lequel la bande de découpe (40) présente une largeur inférieure à la largeur des ouvertures (15).

7. Procédé selon la revendication 5 ou 6, comprenant une étape de meulage de la face inférieure du substrat (1).

8. Procédé selon l'une quelconque des revendications 5 à 7, dans lequel, à l'étape c), la formation de la métallisation (30) comprend une étape de dépôt électrochimique.

## Patentansprüche

1. Oberflächenmontage-Chip, der innerhalb und auf der Oberseite eines Siliziumsubstrats (1) mit einer Vorderseite und einer Seite ausgebildet ist, wobei der Chip Folgendes aufweist:
mindestens eine Metallisierung (30), die konfiguriert um mit einer externen Vorrichtung verlötet zu werden, wobei die Metallisierung einen ersten Abschnitt (30a), der mindestens einen Teil der Vorderseite des Substrats bedeckt, und einen zweiten Abschnitt (30b), der mindestens einen Teil der Seite des Substrats bedeckt, aufweist; **dadurch gekennzeichnet, dass** sie einen porösen Siliziumbereich (20) aufweist, der in dem Substrat enthalten ist und den zweiten Abschnitt (30b) der Metallisierung (30) vom Rest des Substrats isoliert, wobei der zweite Abschnitt (30b) der Metallisierung (30) die Form eines vertieften vertikalen Kanals hat, der in einer vertikalen Nut angeordnet ist, die sich auf der Seite des Substrats (1) befindet.

2. Chip nach Anspruch 1, der ferner Folgendes aufweist:
einen aktiven Bereich (3), der innerhalb und auf der Oberseite des Substrats (1) ausgebildet ist und eine elektronische Schaltung enthält; und
mindestens einen Kontaktbereich (7), der mit der elektronischen Schaltung verbunden ist und sich auf der Vorderseite des Chips befindet,
wobei der erste Abschnitt (30a) der Metallisierung (30) mit dem Kontaktbereich (7) verbunden ist.

3. Chip nach Anspruch 1 oder 2, wobei zwischen der Vorderseite des Substrats (1) und dem ersten Abschnitt (30a) der Metallisierung (30) eine Isolierschicht (5) angeordnet ist.

4. Chip nach Anspruch 3, wobei mindestens ein Teil des porösen Siliziumbereichs (20) eine obere Fläche aufweist, die mit einer unteren Fläche der Isolierschicht (5) in Kontakt steht.

5. Verfahren zum Ausbilden eines Oberflächenmontage-Chips innerhalb und auf einem Siliziumsubstrat (1), wobei das Verfahren die folgenden Schritte aufweist
a) Ätzen einer Öffnung (15) ausgehend von der Oberseite des Substrats (1), wobei diese Öffnung einen Teil einer Seite des Chips definiert;
b) Ausbilden eines porösen Siliziumbereichs (20), der sich in dem Substrat (1) von den Seitenwänden der Öffnung (15) aus erstreckt;
c) Ausbilden einer Metallisierung (30), die konfiguriert ist um an ein externes Bauelement gelötet zu werden, wobei die Metallisierung (30) einen ersten Abschnitt (30a) aufweist, der mindestens einen Teil der Oberseite des Substrats bedeckt und sich in einen zweiten Abschnitt (30b) erstreckt, der sich über die gesamte Oberfläche der Seitenwände der Öffnung (15) erstreckt, so dass der seitliche Abschnitt (30b) vom Rest des Substrats (1) durch einen Abschnitt aus porösem Silizium (20) isoliert ist; und
d) Schneiden entlang eines Schneidbereichs (40), der auf einer die Öffnung (15) kreuzenden Schnittlinie (11) zentriert ist.

6. Verfahren nach Anspruch 5, wobei der Schneidbereich (40) eine geringere Breite als die Breite der Öffnungen (15) aufweist.

7. Verfahren nach Anspruch 5 oder 6, das einen Schritt des Schleifens der Unterseite des Substrats (1) aufweist.

8. Verfahren nach einem der Ansprüche 5 bis 7, wobei im Schritt c) das Ausbilden der Metallisierung (30) einen elektrochemischen Abscheidungsschritt aufweist.

## Claims

1. A surface-mount chip formed inside and on top of a silicon substrate (1) having a front surface and a side, the chip comprising:
at least one metallization (30) configured to be soldered to an external device, this metallization comprising a first portion (30a) covering at least a portion of the front surface of the substrate, and a second portion (30b) covering at least a portion of the side of the substrate; **characterized in that** is comprises a porous silicon region (20), included in the substrate, insulating the second portion (30b) of the metallization (30) from the rest of the substrate, wherein the second portion (30b) of the metallization (30) has the shape of a recessed vertical channel arranged in a vertical groove located on the side of the substrate (1).

2. The chip of claim 1, further comprising:
an active area (3) formed inside and on top of the substrate (1) and containing an electronic circuit; and
at least one contact region (7) connected to the electronic circuit and located on the front surface of the chip,
wherein the first portion (30a) of the metallization (30) is connected to the contact region (7).

3. The chip of claim 1 or 2, wherein an insulating layer (5) is arranged between the front surface of the substrate (1) and the first portion (30a) of the metallization (30).

4. The chip of claim 3, wherein at least a portion of the porous silicon region (20) has an upper face in contact with a lower face of the insulating layer (5).

5. A method of forming a surface-mount chip inside and on top of a silicon substrate (1), the method comprising the steps of:
a) etching an opening (15) from the upper surface of the substrate (1), this opening defining a portion of a side of the chip;
b) forming a porous silicon region (20) extending in the substrate (1) from the lateral walls of the opening (15);
c) forming a metallization (30) configured to be soldered to an external device, this metallization (30) comprising a first portion (30a) covering at least a portion of the upper surface of the substrate, and extending in a second portion (30b) extending over all the surface of the lateral walls of the opening (15) so that the lateral portion (30b) is insulated from the rest of the substrate (1) by a portion of porous silicon (20) ; and
d) cutting along a cutting area (40) centered on a cutting line (11) crossing the opening (15).

6. The method of claim 5, wherein the cutting area (40) has a width smaller than the width of the openings (15).

7. The method of claim 5 or 6, comprising a step of grinding the lower surface of the substrate (1).

8. The method of any of claims 5 to 7, wherein, at step c), the forming of the metallization (30) comprises an electrochemical deposition step.
